# EUROPEAN PATENT APPLICATION

(11) **EP 3 407 295 A1**
(43) Date of publication of application: **28.11.2018**
(21) Application number: 17172137.6
(22) Date of filing: 22.05.2017
(51) Int. Cl.: G06T 7/00, G01R 33/56, A61B 5/055, G01R 33/563

(54) **FIBRE-TRACKING FROM A DIFFUSION-WEIGHTED MAGNETIC RESONANCE IMAGE**

(71) Applicant: Koninklijke Philips N.V., 5656 AE Eindhoven (NL)
(72) Inventor: ZAGORCHEV, Lyubomir Georgiev, 5656 AE Eindhoven (NL)
(74) Representative: de Haan, Poul Erik

(57) **Abstract**

In fibre-tracking from a diffusion weighted magnetic resonance image one or more regions-of-interest are selected from a high-resolution morphological magnetic resonance image. The geometrical relationship between the diffusion-weighted magnetic resonance image and the high-resolution magnetic resonance image is determined. Using the geometrical relationship, one or more region-of-interest corresponding to the anatomical structures represented in the high-resolution morphological image are identified and transferred to the diffusion weighted image space. These regions-of-interest in the diffusion-weighted images form the basis of a fibre tracking procedure. This yields fibre tracts that pass through the selected anatomical structures and enables functional interconnectivity analysis.

## Description

### FIELD OF THE INVENTION

Magnetic resonance imaging (MRI) methods which utilize the interaction between magnetic fields and nuclear spins in order to form two-dimensional or three-dimensional images are widely used nowadays, notably in the field of medical diagnostics, because for the imaging of soft tissue they are superior to other imaging methods in many respects, do not require ionizing radiation and are usually not invasive.

According to the MRI method in general, the body of the patient to be examined is arranged in a strong, uniform magnetic field Bo whose direction at the same time defines an axis (normally the z-axis) of the co-ordinate system to which the measurement is related. The magnetic field Bo causes different energy levels for the individual nuclear spins in dependence on the magnetic field strength which can be excited (spin resonance) by application of an electromagnetic alternating field (RF field) of defined frequency (so-called Larmor frequency, or MR frequency). From a macroscopic point of view the distribution of the individual nuclear spins produces an overall magnetization which can be deflected out of the state of equilibrium by application of an electromagnetic pulse of appropriate frequency (RF pulse) while the corresponding magnetic field B₁ of this RF pulse extends perpendicular to the z-axis, so that the magnetization performs a precession motion about the z-axis. The precession motion describes a surface of a cone whose angle of aperture is referred to as flip angle. The magnitude of the flip angle is dependent on the strength and the duration of the applied electromagnetic pulse. In the example of a so-called 90° pulse, the magnetization is deflected from the z axis to the transverse plane (flip angle 90°).

After termination of the RF pulse, the magnetization relaxes back to the original state of equilibrium, in which the magnetization in the z direction is built up again with a first time constant T₁ (spin lattice or longitudinal relaxation time), and the magnetization in the direction perpendicular to the z-direction relaxes with a second and shorter time constant T₂ (spin-spin or transverse relaxation time). The transverse magnetization and its variation can be detected by means of receiving RF antennae (coil arrays) which are arranged and oriented within an examination volume of the magnetic resonance examination system in such a manner that the variation of the magnetization is measured in the direction perpendicular to the z-axis. The decay of the transverse magnetization is accompanied by dephasing taking place after RF excitation caused by local magnetic field inhomogeneities facilitating a transition from an ordered state with the same signal phase to a state in which all phase angles are uniformly distributed. The dephasing can be compensated by means of a refocusing RF pulse (for example a 180° pulse). This produces an echo signal (spin echo) in the receiving coils.

In order to realize spatial resolution in the subject being imaged, such as a patient to be examined, constant magnetic field gradients extending along the three main axes are superposed on the uniform magnetic field Bo, leading to a linear spatial dependency of the spin resonance frequency. The signal picked up in the receiving antennae (coil arrays) then contains components of different frequencies which can be associated with different locations in the body. The signal data obtained via the receiving coils correspond to the spatial frequency domain of the wave-vectors of the magnetic resonance signal and are called k-space data. The k-space data usually include multiple lines acquired of different phase encoding. Each line is digitized by collecting a number of samples. A set of k-space data is converted to an MR image by means of Fourier transformation.

The transverse magnetization dephases also in presence of constant magnetic field gradients. This process can be reversed, similar to the formation of RF induced (spin) echoes, by appropriate gradient reversal forming a so-called gradient echo. However, in case of a gradient echo, effects of main field inhomogeneities, chemical shift and other off-resonances effects are not refocused, in contrast to the RF refocused (spin) echo.

By suitable preparation of the magnetisation various aspects of the spins to be imaged can be encoded into the magnetic resonance signals. For example by application of biploar gradient magnetic field diffusion-encoding pulses, diffusion of spins may be encoded into the longitudinal magnetisation. This encoding then is transferred to the read-out magnetic resonance signals via the transverse RF excitation.

The invention pertains to a fibre-tracking from a diffusion-weighted magnetic resonance image.

### BACKGROUND OF THE INVENTION

A fibre-tracking method from a diffusion-weighted magnetic resonance image is known from the international application WO2016/041577**.** This known method of fibre-tracking from a diffusion-weighted magnetic resonance image makes use of an atlas image that is registered with the diffusion-weighted image. Seed regions for the fibre-tracking are determined using the atlas image. On the basis of the transformation between the atlas image and the diffusion-weighted image the seed regions are determined in the diffusion-weighted image. These seed regions are employed as the starting points for the fibre-tracking procedure to extract the fibre-tracts from the diffusion-weighted image.

### SUMMARY OF THE INVENTION

An object of the present invention is to provide a method of fibre-tracking from a diffusion-weighted magnetic resonance image that more accurately extracts fibre-bundles passing through particular structural objects.

This object is achieved by the method of fibre-tracking from a diffusion-weighted magnetic resonance image:
- access a diffusion weighted MR image dataset,
- access a high-resolution morphological image dataset,
- determine one or more structural objects in the high-resolution morphological image,
- determination of a geometrical relationship between the diffusion-weighted image and the high-resolution morphological image,
- selection of one or more regions-of-interest from the structural object(s),
- transfer the selected regions-of-interest from the high-resolution morphological image dataset to the diffusion-weighted image dataset on the basis of the geometrical relationship and
- apply a fibre-tracking procedure to the diffusion-weighted MR image dataset using the transferred selection regions as starting points to derive a fibre-track dataset representing neurological fibre bundles.

According to the invention the high-resolution morphological image and the diffusion-weighted image datasets relate to the same patient's anatomy and water-diffusion structures in that anatomy. The one or more regions-of-interest selected from the high-resolution image are transferred to the diffusion weighted image using the geometrical relationship between the high-resolution image and the diffusion-weighted image. Because both the high-resolution morphological dataset and the diffusion-weighted dataset relate to the same patient's anatomy, the region-of-interest in the diffusion-weighted image accurately correspond to the anatomical structural objects selected as regions-of-interest from the high-resolution morphological image. Thus, the structural objects include well-defined anatomical regions, such as organs or sub-structures within organs. The higher the correlation between the high-resolution morphological image and the diffusion-weighted image datasets, the more accurately the regions-of-interest transferred to the diffusion weighted-image correspond to the structural objects in the high-resolution morphological image dataset. This higher correlation ultimately provides for more accurate extraction of fibre-bundles passing through these structural objects from the diffusion-weighted image dataset. The high spatial resolution and good contrast in the high-resolution morphological image enable the selection of the region-of-interest. The transfer of the regions-of-interest to the diffusion-weighted image can be carried-out in a (semi-) automatic manner, with little or no human intervention. The high-resolution morphological image, having isotropic voxel size of e.g. less than or equal to 1mm, can be segmented with a fully automatic approach (e.g. shape-constrained brain model) and then registered with the diffusion weighted image. The registration is automatic and enables transformation of the geometry extracted from the morphological image to the diffusion weighted image. Direct extraction of anatomical regions from the diffusion weighted image is often not reliable or even not successful. This is because the voxel-size in a diffusion weighted or diffusion tensor image is several times larger than the typical voxel size of the high-resolution morphological image and the DWI does not provide enough contrast to differentiate boundaries of brain structures. In an implementation of the invention, information on a presumed disease or patient conditions may be input by the (human) operator or accessed from e.g. a hospital information system. The input information is then taken into account to a more directed selection of the regions-of-interest that are more pertinent in relation to the input disease information. The more accurate determination of the regions-of-interest as starting points for the fibre tracking process leads to more accurate extraction of the fibre-bundles so that a more accurate representation of neurological interconnectivity structures between structural objects in the patient's (notably brain) anatomy is obtained. It also ensures reproducibility of subsequent tract measurements, which achieves higher accuracy and reliability in longitudinal clinical studies.

In brief, in fibre-tracking from a diffusion weighted magnetic resonance image one or more regions-of-interest are selected from a high-resolution morphological magnetic resonance image. The geometrical relationship between the diffusion-weighted magnetic resonance image and the high-resolution magnetic resonance image is determined. Using the geometrical relationship, one or more region-of-interest corresponding to the anatomical structures represented in the high-resolution morphological image are identified. These regions-of-interest are transformed to align with the diffusion-weighted image and form the basis of a fibre tracking procedure. This yields fibre tracts that run between the selected anatomical structures. The prior art, however, appears never to have recognised the relative inaccuracy of the known method of fibre-tracking.

These and other aspects of the invention will be further elaborated with reference to the embodiments defined in the dependent Claims.

In a preferred implementation of the invention, the high-resolution morphological image dataset and the diffusion-weighted image dataset are acquired in a common (magnetic resonance) imaging procedure. These datasets can be acquired successively, with the patient to be examined in the same position in a magnetic resonance examination system's examination zone. That is, the patient to be examined is positioned once in the examination zone to have the several image datasets acquired by different magnetic resonance acquisition protocols. That is, the patient to be examined does not need to leave the examination zone in between the acquisitions of the image datasets. In this way errors due to repositioning the patient to be examined are avoided. The diffusion-weighted image dataset and the high-resolution morphological image dataset may be acquired in an interleaved manner in that (groups of) k-space profiles of the diffusion-weighted MR image dataset of the high-resolution morphological image dataset are acquired in an interleaved or alternating manner.

In another preferred implementation of the invention, several fibre bundles are extracted in parallel for respective different structural objects. The accuracy of the determination of the regions-of-interest in the diffusion-weighted datasets allows for fibre-tracking in parallel of fibre-tracts from the diffusion-weighted image passing through respective structural objects selected from the high-resolution morphological image. The parallel fibre-tracking for fibre tracts passing through respective structural objects is also supported in the structural objects may be (semi-)automatically segmented from the high-resolution morphological image. The accurate determination of regions-of-interest as starting points in the diffusion-weighted image leads to a shortening of the processing time of the fibre-tracking process to extract the fibre-tracts. According to this aspect of the invention, there is no need for the user to manually delineate a region of interest to start the tract extraction process. That manual delineation is both time consuming and user dependent and hence not well reproducible. Furthermore, the invention achieves that fibre-tracking from multiple regions can be performed in parallel.

In a further preferred implementation the extracted fibre-tracts are labelled according to the structural objects in the diffusion-weighted image they pass through. This provides a better accessible representation of the interconnectivity structure in the patient's (brain) anatomy. Notably, additional information is provided on the association of structural objects and fibre-bundles. In an enhanced implementation the labels may be employed to easily select fibre-tracts limited to those that pass through particular selected structural objects in the patient's anatomy. Also entry points and exit points at common boundaries between structural objects can be mapped by comparing their (image) coordinates and labels. This enables a reproducible quantification of inter-structure connectivity.

In a further preferred implementation, the determination of the one or more structural objects in the high-resolution morphological image is done by warping a deformable shape-constrained brain model to the high-resolution morphological image. This further supports the (semi-)automatic determination or identification of the structural objects from the high-resolution morphological image dataset.

Useful examples of the high-resolution morphological datasets are a T₁-weighed or a T₂-weighted magnetic resonance image. Further a diffusion tensor imaging approach appears a useful technique to acquire the diffusion-weighted image dataset.

The invention further pertains to a computer programme including instructions to control an magnetic resonance examination system to carry-out the method of the invention in its various implementations. The computer programme of the invention can be provided on a data carrier such as a CD-rom disk or a USB memory stick, or the computer programme of the invention can be downloaded from a data network such as the world-wide web. When installed in the computer included in a magnetic resonance imaging system the magnetic resonance imaging system is enabled to operate according to the invention. The reconstruction of the magnetic resonance images, identification of structural objects, geometry transfer and fibre-tracking may be done by processing software of the magnetic resonance examination system, of a separate workstation or could even be done remotely, e.g. by processing capacity in 'the cloud' at remote locations.

These and other aspects of the invention will be elucidated with reference to the embodiments described hereinafter and with reference to the accompanying drawing wherein

### BRIEF DESCRIPTION OF THE DRAWINGS

Figure 1 shows a schematic representation of the method of the invention;
   Details of the fibre-tracking process are shown in the schematic representation in Figure 2 and
Figures 3a, b, c show an illustration as one particular example of the common tracts that pass through the corpus callosum and the brainstem

### DETAILED DESCRIPTION OF THE EMBODIMENTS

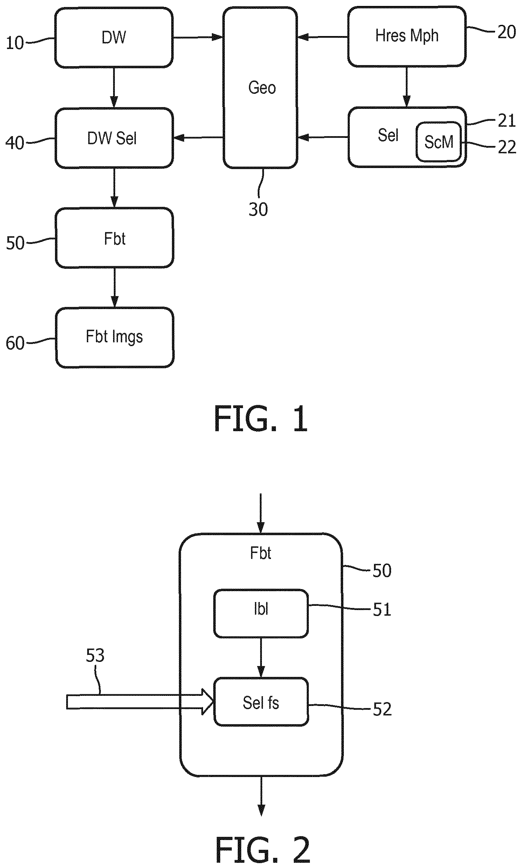

Figure 1 shows a schematic representation of the method of the invention. The diffusion weighted or diffusion tensor MR image dataset 10 is accessed as is the high-resolution morphological dataset 20. By way of a geometry analysis 30, the geometry of the high-resolution morphological data set 20 is related to the geometry of the diffusion weighted MR data set. This results in the determination of the geometry transformation 30 between the high-resolution morphological image data set and the diffusion weighted MR image data set.

One or more regions-of-interest 21 are selected from the high-resolution morphological image data set and by way of the geometry transformation mapped into corresponding regions-of-interest 40 in the diffusion weighted MR image dataset. For example, the regions-of-interest selected may be the corpus callosum and the brain stem in order to derive fibre tracts 50 running between these two structures. These regions-of-interest can be accurately segmented from the high-resolution morphological image because that has the smaller voxel size and the better contrast resolution. The selected regions-of-interest are then transferred into the diffusion weighted (tensor) MR image. Directly segmenting structures from the diffusion weighted MR image dataset is far less reliable or even not possible. Accurate delineation of anatomical structures from the high-resolution morphological image may be done using a deformable shape-constrained model 22. This model is known per se from the paper 'Shape-constrained deformable models and application in medical imaging' by J. Weese et al. in 'Shape analysis in medical image analysis'(2014) (pp. 151-184). A fully-automatic, deformable shape-constrained brain model can delineate the boundary of anatomical structures in a T₁-weighted structural MRI image (acquired simultaneously and/or co-registered with the DTI image).

On the basis of the selected 40 regions-of-interest in the diffusion weighted MR image data set a fibre-tracking method 50 is applied to extract the fibre structures connecting or passing through the selected regions-of-interest. An image representation 60 is made of the extracted fibres. Furthermore, major tracts in the brain are not limited to a single anatomical brain structure. For example, tracts from the spinal cord to the cerebral cortex that convey information about touch, movement and spatial orientation travel through a number of different sub-cortical brain regions along that way. In the approaches of the prior art, single regions of interest (either in 3D or on 2D slices) are used to start the tract extraction but the process does not take into account the actual brain anatomy in the subsequent tract tracing. The functionality to extract only tracts that pass through a number of physically different but functionally connected volumetric anatomical brain regions is provided by the present invention. Notably, 1) an automated method for tract extraction that segments brain structures in a T₁-weighted image and transfers the geometry of multiple anatomical regions to the DTI space for extraction of major known tracts simultaneously and in parallel, 2) a method for labelling of extracted tracts within anatomical brain structure that allows the identification of major known tracts and interconnectivity analysis between adjacent anatomical brain structures, and 3) a configuration file that stores the list of relevant anatomical brain regions in a disease- or patient-specific context.

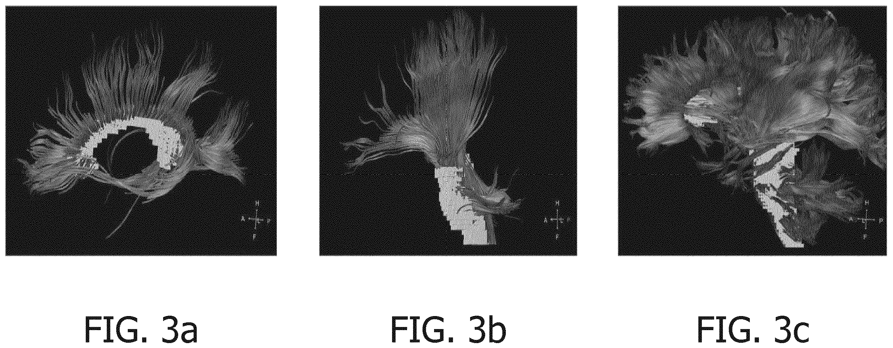

The geometry defining the anatomical regions or structural objects in the T₁-weighted image can be extracted from the model and transferred to the DTI space and multiple anatomical regions can be used to start the extraction of major known tracts simultaneously. An illustration of the common tracts that pass through the corpus callosum and the brainstem are shown as one particular example shown in Figures 3a, b, c. Please note that the same approach can be used to extract connected tracts that pass through an arbitrary number of brain structures.

Details of the fibre-tracking process are shown in the schematic representation in Figure 2. The fibre-tracking process 50 includes a labelling procedure 51 labelling fibre tracts according to the regions-of-interest or anatomic (e.g. brain) structures thy pass through. Dependent on the number of structures the fibre tract passes through, the labelling relates to one or several regions-of-interest or anatomical structures. The fibre tracking process also includes a selection process 52 to select the extracted fibres having a particular label. This label for which the fibre tracks may be selected can be input 53 by the operator or may be made available in accordance with the presumed disease.

Tracts can be labelled within anatomical brain structure to identify major fibre bundles that pass through a number of different structures or to remove irrelevant tracts. The latter can be performed either as post-processing, or at structure boundaries, depending on the extracted tract labels. For example, if we are only interested in tracts that pass through three adjacent anatomical brain structures, all tracts that contain any one or two of the three labels can be removed. Tracts that pass through all three regions (have all three labels) can be kept for subsequent analysis. Also, entry/exit points at common structure boundaries can be mapped by comparing their coordinates and anatomical labels. That enables reproducible quantification of inter-structure connectivity. The list of relevant brain regions depends on the clinical application and can be stored in a configuration file that could contain additional disease- or patient-specific context.

## Claims

**1.** A method of fibre-tracking from a diffusion-weighted magnetic resonance image comprising
- access a diffusion weighted MR image dataset,
- access a high-resolution morphological image dataset,
- determine one or more structural objects in the high-resolution morphological image,
- determination of a geometrical relationship between the diffusion-weighted image and the high-resolution morphological image,
- selection of one or more regions-of-interest from the structural object(s),
- transfer the selected regions-of-interest from the high-resolution morphological image dataset to the diffusion-weighted image dataset on the basis of the geometrical relationship and
- apply a fibre-tracking procedure to the diffusion-weighted MR image dataset using the transferred selection regions as starting points to derive a fibre-track dataset representing neurological fibre bundles.

**2.** A method of fibre-tracking as claimed in Claim 1, wherein a the diffusion weighted MR image dataset and the high-resolution morphological image dataset are acquired in a common examination procedure, in particular the diffusion weighted MR image dataset and the high-resolution morphological image dataset are acquired successively or in an interleaved manner.

**3.** A method of fibre-tracking as claimed in Claim 1, wherein several fibre-bundles associated with respective structural objects are extracted in parallel from the diffusion-weighted MR dataset.

**4.** A method of fibre-tracking of Claim 1 or 2, including labelling the extracted fibres in the fibre-track dataset according to the structural object(s) through which the respective extracted fibre pass.

**5.** A method of fibre tracking of Claim 3 including selection of tracked fibre-bundles in accordance with their label assigned on the basis of respective structural objects.

**6.** A method of fibre-tracking of any one of the preceding Claims, wherein the determination of the one or more structural objects in the high-resolution morphological image is done by warping a deformable shape-constrained brain model to the high-resolution morphological image.

**7.** A method of fibre-tracking of any one of the preceding Claims, in which the selection of one or more regions-of-interest is based on input information relating to a presumed disease.

**8.** A computer programme comprising instructions to:
- access a diffusion weighted MR image dataset,
- access a high-resolution morphological image dataset
- determine one or more structural objects in the high-resolution morphological image,
- determination of a geometrical relationship between the diffusion-weighted image and the high-resolution morphological image,
- selection of one or more regions-of-interest from the structural object(s),
- transfer the selected regions-of-interest from the high-resolution morphological image dataset to the diffusion-weighted image dataset on the basis of the geometrical relationship and
- apply a fibre-tracking procedure to the diffusion-weighted MR image dataset using the transferred selection regions as starting points to derive a fibre-track dataset representing neurological fibre bundles.

**0.** A workstation configured to perform the method of fibre-tracking as defined in any one of Claims 1 to 7, or in which the computer programme of Claim 8 is installed.
